# EUROPEAN PATENT APPLICATION

(11) **EP 4 510 418 A1**
(43) Date of publication of application: **19.02.2025**
(21) Application number: 24172146.3
(22) Date of filing: 24.04.2024
(51) Int. Cl.: H02J 7/00

(54) **METHOD AND APPARATUS FOR DIAGNOSING DEFECTIVE BATTERY PACK ASSEMBLY**

(30) Priority: 18.08.2023 KR 20230108262
(71) Applicant: Samsung SDI Co., Ltd., Yongin-si, Gyeonggi-do 17084 (KR)
(72) Inventor: Kim, Taejin, 17084 Yongin-si, Gyeonggi-do (KR)
(74) Representative: Gulde & Partner

(57) **Abstract**

Provided is a method of diagnosing an assembly defect of a battery pack, the method including calculating an internal resistance value of a battery module (110) including battery cells (111) in the battery pack, calculating an internal resistance value of a battery control unit, BCU, (100) in the battery pack and configured to control charging/discharging of the battery module (110), and comparing a first voltage value of the battery pack with a second voltage value of the battery pack, the first voltage value being calculated based on the internal resistance value of the battery module (110) and the internal resistance value of the BCU (100), and the second voltage value being a measured voltage value of the battery pack.

## Description

### BACKGROUND

### 1. Field

One or more embodiments relate to a method, a computer program, and an apparatus for diagnosing an assembly defect of a battery.

### 2. Description of the Related Art

Recently, with the rapidly increasing desire for portable electronic products, such as laptops, video cameras, mobile phones, and the like, and with the intensified development of energy storage batteries, robots, satellites, and the like, research on high-performance secondary batteries capable of repeated charging/discharging has been actively conducted.

Currently commercialized secondary batteries include nickel cadmium batteries, nickel hydrogen batteries, nickel zinc batteries, lithium secondary batteries, and the like. Among them, lithium secondary batteries have little to no memory effect compared with nickel-based secondary batteries, and thus have attracted attention for their merits of free charging/discharging, a very low self-discharge rate, and high energy density.

For example, recently, with the steady exhaustion of carbon energy and the increasing interest in environmental issues, the desire for hybrid vehicles and electric vehicles has gradually increased around the world including the United States, Europe, Japan, and the Republic of Korea. Hybrid vehicles or electric vehicles obtain vehicle-driving power by using the charging/discharging energy of battery packs. Compared with vehicles powered by an engine alone, hybrid vehicles or electric vehicles have higher fuel efficiency and can eliminate or lessen the emission of pollutants, and thus have gained positive responses from many consumers. More attention and research have been focused on vehicle batteries, which are a key component of hybrid vehicles or electric vehicles.

Battery packs include various components including battery modules including a plurality of battery cells. Such battery modules and components may be wired to each other by welding, bolting, connecting, or the like during assembly, and thus, assembly defects may occur during wiring.

### SUMMARY

One or more embodiments include a method, computer program, and apparatus for diagnosing an assembly defect of a battery to effectively diagnose an assembly defect in a process of diagnosing an assembly defect of a battery pack.

However, such an objective is merely an example, and the scope of the present disclosure is not limited thereto.

Additional aspects will be set forth in part in the description which follows and, in part, will be apparent from the description, or may be learned by practice of the presented embodiments of the present disclosure.

According to one or more embodiments, a method of diagnosing an assembly defect of a battery pack includes calculating an internal resistance value of a battery module including battery cells in the battery pack, calculating an internal resistance value of a battery control unit (BCU) in the battery pack and configured to control charging/discharging of the battery module, and comparing a first voltage value of the battery pack with a second voltage value of the battery pack, the first voltage value being calculated based on the internal resistance value of the battery module and the internal resistance value of the BCU, and the second voltage value being a measured voltage value of the battery pack.

The calculating of the internal resistance value of the battery module may include using both ends of the battery module as measurement points.

The calculating of the internal resistance value of the battery module may be based on an amount of change of the internal resistance value of the battery module corresponding to a battery deterioration state corresponding to a battery cell model.

The method may further include calculating, based on a current deterioration state, an internal resistance value of the battery pack by adding the internal resistance value of the battery module and the internal resistance value of the BCU, the internal resistance value of the battery module reflecting the amount of the change of the internal resistance value according to the battery deterioration state, may further include calculating the first voltage value by multiplying the internal resistance value of the battery pack by a value of a current flowing through both of the ends of the battery pack, and may further include comparing a magnitude of the first voltage value with a magnitude of the second voltage value obtained by measuring a voltage at both of the ends of the battery pack.

The method may further include determining the magnitude of the second voltage value is greater than the magnitude of the first voltage value.

The calculating of the internal resistance value of the BCU may be based on using measurement points for components in the BCU.

One or more embodiments provide a computer program stored on a recording medium to execute the method by using a computing device.

According to one or more embodiments, an apparatus for diagnosing an assembly defect of a battery pack includes a battery module in the battery pack and including battery cells, a battery control unit (BCU) in the battery pack and configured to control charging/discharging of the battery module, and a processor configured to calculate an internal resistance value of the battery module, to calculate an internal resistance value of the BCU, and to diagnose the assembly defect of the battery pack by comparing a first voltage value of the battery pack with a second voltage value of the battery pack, the first voltage value being calculated based on the internal resistance value of the battery module and the internal resistance value of the BCU, and the second voltage value being a measured voltage value of the battery pack.

The processor may be further configured to use both ends of the battery module as measurement points.

The processor may be further configured to calculate the internal resistance value of the battery module based on an amount of change of the internal resistance value of the battery module corresponding to a battery deterioration state corresponding to a battery cell model.

The processor may be further configured to calculate, based on a current deterioration state, an internal resistance value of the battery pack by adding the internal resistance value of the battery module and the internal resistance value of the BCU, the internal resistance value of the battery module reflecting the amount of the change of the internal resistance value according to the battery deterioration state, may be further configured to calculate the first voltage value by multiplying the internal resistance value of the battery pack by a value of a current flowing through both ends of the battery pack, and may be further configured to compare a magnitude of the first voltage value with a magnitude of the second voltage value obtained by measuring a voltage at both of the ends of the battery pack.

The processor may be further configured to, when the magnitude of the second voltage value is greater than the magnitude of the first voltage value, diagnose that there is the assembly defect in the battery pack.

The processor may be further configured to calculate the internal resistance value of the BCU based on using measurement points for components assembled and provided in the BCU.

The BCU may include the processor, a contactor, a fuse, and a shunt resistor.

The battery cells may be rechargeable secondary batteries selected from at least one among a nickel-cadmium battery, a lead acid battery, a nickel metal hydride battery, a lithium ion battery, a lithium polymer battery.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF DRAWINGS

The above and other aspects of certain embodiments of the present disclosure will be more apparent from the following description taken in conjunction with the accompanying drawings, in which:
FIG. 1 schematically shows a battery pack according to embodiments of the present disclosure;
FIG. 2 is a diagram for explaining a method of diagnosing an assembly defect of a battery pack, according to embodiments of the present disclosure;
FIG. 3 is a flowchart for explaining a method of diagnosing an assembly defect of a battery pack, according to embodiments of the present disclosure; and
FIG. 4 is a graph for explaining an amount of change of an internal resistance value according to a battery deterioration state, according to embodiments of the present disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Processes, elements, and techniques that are redundant, that are unrelated or irrelevant to the description of embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. This may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only when the portion is "directly beneath" another portion but also when there is further another portion between the portion and another portion. Other expressions describing relationships between components such as "between," "immediately between" or "adjacent to" and "directly adjacent to" may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression such as "at least one of A and B" and "at least one of A or B" may include A, B, or A and B. As used herein, "or" generally means "and/or," and the term "and/or" includes any and all combinations of one or more of the associated listed items. For example, the expression such as "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure as defined by the appended claims. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. Each block, unit, and/or module may be implemented by dedicated hardware, or a combination of dedicated hardware that performs some functions and a processor (for example, one or more programmed microprocessors and related circuits) that performs a function different from those of the dedicated hardware. In some embodiments, the block, unit, and/or module may be physically separated into two or more interact individual blocks, units, and/or modules without departing from the scope of the present disclosure. In some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

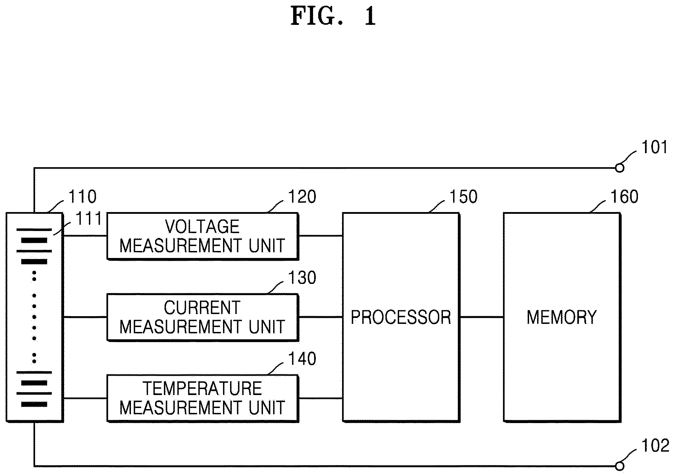

FIG. 1 schematically shows a battery pack according to embodiments of the present disclosure.

Referring to FIG. 1, the battery pack according to embodiments of the present disclosure may include a battery module 110, a processor 150, a memory 160, a voltage measurer (e.g., voltage measurement unit) 120, a current measurer (e.g., current measurement unit) 130, and a temperature measurer (e.g., temperature measurement unit) 140.

The battery module 110 may include a plurality of battery cells 111, and the battery cells 111 may be rechargeable secondary batteries. For example, the battery cells 111 may include at least one selected from among a nickel-cadmium battery, a lead acid battery, a nickel metal hydride (NiMH) battery, a lithium ion battery, a lithium polymer battery, and/or the like.

A number and a connection method of the battery cells 111 included in the battery module 110 may be determined based on an amount of power and a voltage suitable for the battery pack. Although FIG. 1 shows, for conceptual purposes only, that the battery cells 111 included in the battery module 110 are connected to each other in series, the battery cells 111 may be connected to each other in parallel, or in series and parallel. Although FIG. 1 shows, for conceptual purposes only, that the battery pack includes one battery module 110, the battery pack may include a plurality of the battery modules 110 connected to each other in series, in parallel, or in series and in parallel. The battery module 110 may include only one battery cell 111.

The battery module 110 may include a plurality of battery modules, each battery module including a plurality of battery cells 111. The battery pack may include a pair of pack terminals 101 and 102 to which an electrical load or a charging device may be connected.

In the present specification, a corresponding aspect of an assembly defect diagnosis may be the battery pack or at least one battery module 110 included in the battery pack.

The battery pack according to embodiments of the present disclosure may include one or more switches. The switch(es) may be connected between the battery module 110 and one or more of the pack terminals 101 and 102 (e.g., the pack terminal 101). The switch may be controlled by the processor 150. In one or more embodiments, the battery pack may further include a battery protection circuit, a fuse, a current sensor, and the like.

An apparatus for diagnosing an assembly defect of a battery pack, according to embodiments of the present disclosure, may include the processor 150 and the memory 160.

The processor 150 may control the overall operation of the apparatus for diagnosing an assembly defect of a battery pack. For example, the processor 150 may be implemented in a form to selectively include a processor, an application-specific integrated circuit (ASIC), a chipset, a logic circuit, a register, a communication modem, and/or a data processing device, so as to perform the operation described above.

The processor 150 may perform arithmetic, logic, and/or input/output operations, and may execute, for example, program code stored in the memory 160. The processor 150 may store data in the memory 160, or may load data stored in the memory 160.

The memory 160 may be a recording medium that is readable by the processor 150, and may include a permanent mass storage device, such as random access memory (RAM), read only memory (ROM), and a disk drive. The memory 160 may store an operating system and at least one program or application code. The memory 160 may store program code or data according to embodiments of the present disclosure. For example, the data may include a charging/discharging current, terminal voltage, and/or temperature of a battery.

The memory 160 may store program code for estimating a state of charge (SOC) of a battery by using data generated by measuring at least one parameter of the battery module 110, and may store SOC-open circuit voltage (OCV) data. In one or more embodiments, the memory 160 may store program code or data for estimating a state of health (SOH) of a battery by using data generated by measuring at least one parameter of the battery module 110. Here, the SOH of the battery may indicate a deterioration state of the battery.

For example, at least one parameter of the battery module 110 may include a component or variable, such as a terminal voltage, charging/discharging current, and/or ambient temperature of the battery module 110.

The apparatus for diagnosing an assembly defect of a battery pack, according to embodiments of the present disclosure may further include the voltage measurer 120, the current measurer 130, and the temperature measurer 140 for measuring at least one parameter of the battery module 110. The apparatus for diagnosing an assembly defect of a battery pack may further include a communication module for communicating with other devices, such as an electronic control device of a vehicle, a controller of a charging device, and the like.

The voltage measurer 120 may be configured to measure a voltage of the battery module 110. For example, as shown in the configuration of FIG. 1, the voltage measurer 120 may be electrically connected to both ends of the battery module 110 and/or the battery cell 111. In one or more embodiments, the voltage measurer 120 may be electrically connected to the processor 150 to transmit and receive electrical signals. In one or more embodiments, the voltage measurer 120 may measure a voltage of both ends of the battery module 110 and/or the battery cell 111 at a time interval under the control by the processor 150, and may output a signal indicating a magnitude of the measured voltage to the processor 150. The processor 150 may determine the voltage of the battery module 110 and/or the battery cell 111 from the signal output from the voltage measurer 120. For example, the voltage measurer 120 may be implemented by using a voltage measurement circuit.

In one or more embodiments, the current measurer 130 may be configured to measure a current of a battery. For example, the current measurer 130 may be electrically connected to a current sensor provided on a charging/discharging path of the battery module 110 and/or the battery cell 111. In one or more embodiments, the current measurer 130 may be electrically connected to the processor 150 to transmit and to receive electrical signals. In one or more embodiments, the current measurer 130 may repeatedly measure a magnitude of a charging current or a discharging current of the battery module 110 and/or the battery cell 111 at a time interval under the control by the processor 150, and may output a signal indicating the magnitude of the measured current to the processor 150. At this time, the processor 150 may determine the magnitude of the current from the signal output from the current measurer 130. For example, the current sensor may be implemented by using a Hall sensor or sense a resistor.

The temperature measurer 140 may be configured to measure a temperature of a battery. For example, as shown in the configuration of FIG. 1, the temperature measurer 140 may be connected to the battery module 110 and/or to the battery cell 111 to measure a temperature of a secondary battery provided in the battery module 110 and/or the battery cell 111. In one or more embodiments, the temperature measurer 140 may be electrically connected to the processor 150 to transmit and to receive electrical signals. In one or more embodiments, the temperature measurer 140 may repeatedly measure the temperature of the secondary battery at a time interval, and may output a signal indicating a magnitude of the measured temperature to the processor 150. At this time, the processor 150 may determine the temperature of the secondary battery from the signal output from the temperature measurer 140. For example, the temperature measurer 140 may be implemented by using a thermocouple.

In one or more embodiments, the processor 150 may estimate an SOC of the battery module 110 by using at least one of a voltage measurement value, a current measurement value, and/or a temperature measurement value of the battery module 110, which are respectively received from the voltage measurer 120, the current measurer 130, and the temperature measurer 140. Here, the SOC may be calculated as a value corresponding to a remaining amount of charge of the battery module 110 in the range of about 0% to about 100%. In one or more embodiments, the processor 150 may estimate an SOH of the battery module 110 by using at least one of a voltage measurement value, a current measurement value, and/or a temperature measurement value of the battery module 110, which are respectively received from the voltage measurer 120, from the current measurer 130, and/or from the temperature measurer 140, and may estimate SOC data of the battery module 110. Here, the SOH may be calculated as a value corresponding to a remaining amount of charge of the battery module 110 in the range of about 0% to about 100%.

According to aspects of the present disclosure, the processor 150 may estimate an SOC of the battery module 110 by integrating a charging current and a discharging current of the battery module 110. If charging or discharging of the battery module 110 starts, an initial value of the SOC of the battery module 110 may be determined by using an OCV of the battery module 110, which may have been measured before the charging or discharging of the battery module 110 starts. In one or more embodiments, the processor 150 may include an SOC-OCV lookup table, in which an SOC is defined for each OCV, and may map an SOC corresponding to the OCV of the battery module 110 from the lookup table.

The processor 150 may estimate an SOC of the battery module 110 by using an extended Kalman filter. The extended Kalman filter refers to a mathematical algorithm for adaptively estimating an SOC of a secondary battery by using a voltage, a current, and a temperature of the secondary battery.

The SOC of the battery module 110 may also be determined by other known methods, by which the SOC may be estimated by selectively utilizing a voltage, a current, and a temperature of a secondary battery, the methods being other than the current integration method or extended Kalman filter described above.

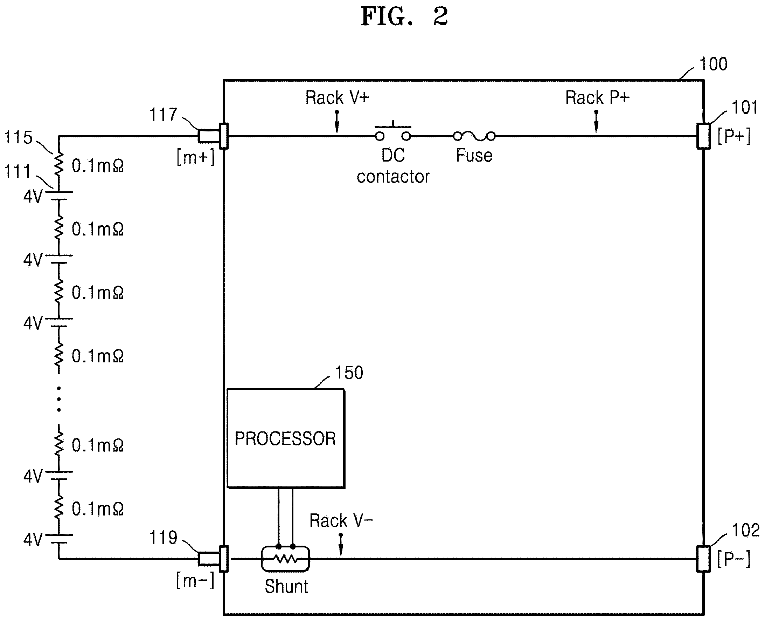

FIG. 2 is a diagram for explaining a method of diagnosing an assembly defect of a battery pack, according to embodiments of the present disclosure.

Referring to FIGS. 1 and 2 together, the battery pack according to embodiments of the present disclosure may include the battery module 110 and a battery control unit (BCU) 100. For example, as shown in FIG. 2, the BCU 100 may include the processor 150, a contactor, a fuse, and a shunt resistor. However, the present disclosure is not limited thereto, and the BCU 100 according to embodiments of the present disclosure may further include a battery protection circuit, a voltage measurement circuit, a current measurement circuit, a temperature measurement circuit, and/or the like.

The battery module 110 according to embodiments of the present disclosure may be provided in the battery pack, and may include a plurality of battery cells 111. The BCU 100 according to embodiments of the present disclosure may be provided in the battery pack, and may control charging/discharging of the battery module 110.

The processor 150 according to embodiments of the present disclosure may calculate an internal resistance value of the battery module 110. In one or more embodiments, the processor 150 may calculate an internal resistance value of the BCU 100. In one or more embodiments, the processor 150 may diagnose an assembly defect of the battery pack by comparing a first voltage value of the battery pack with a second voltage value of the battery pack, which is a measured voltage value of the battery pack. Here, the first voltage value may be calculated based on the internal resistance value of the battery module 110 and the internal resistance value of the BCU 100.

In one or more embodiments, the processor 150 may obtain an internal resistance value measured (e.g., pre-measured) by using both ends of the battery module 110 as measurement points.

In one or more embodiments, the processor 150 may calculate the internal resistance value of the battery module 110 based on an amount of change of an internal resistance value according to a battery deterioration state, which may be stored (e.g., pre-stored) according to a model of the battery cell 111.

In one or more embodiments, the processor 150 may calculate, based on a current deterioration state, an internal resistance value of the battery pack by adding the internal resistance value of the battery module 110 and the internal resistance value of the BCU 100, the internal resistance value of the battery module 110 reflecting the amount of change of the internal resistance value according to the battery deterioration state.

In one or more embodiments, the processor 150 may calculate the first voltage value by multiplying the internal resistance value of the battery pack by a value of a current flowing through both ends of the battery pack. In one or more embodiments, the processor 150 may compare a magnitude of the first voltage value with a magnitude of the second voltage value, which may be obtained by measuring a voltage at both ends of the battery pack. If the magnitude of the second voltage value is greater than the magnitude of the first voltage value, the processor 150 may diagnose that there is an assembly defect in the battery pack.

In one or more embodiments, the processor 150 may calculate the internal resistance value of the BCU 100 based on an internal resistance value, which may be measured (e.g., pre-measured) by using measurement points (e.g., preset measurement points) for each component assembled and provided in the BCU 100.

The battery pack may be wired to other components by welding, bolting, connecting, or the like during assembly, and thus, it may be suitable to diagnose an assembly defect of a wiring portion. Contact resistance of a contact portion during wiring may be expressed as internal resistance. For example, as shown in FIG. 2, 300 battery cells 111 may be provided in the battery module 110 or a battery rack. Here, the battery rack may include a plurality of battery modules. In one or more embodiments, the battery module 110 including 300 battery cells 111 may be described, but the present disclosure is not limited thereto and may be described with a battery rack including a plurality of battery modules.

For example, if there are 300 battery cells 111 with a voltage of about 4 V, if a charging current of about 300 A flows, the sum of the cell voltages may represent about 1,200 V. In one or more embodiments, if contact resistance 115 of a contact portion in which each battery cell 111 is assembled is about 0.1 mΩ, total contact resistance due to 300 contact portions may be about 30 mΩ, and an internal resistance value of the battery module 110 may be about 30 mΩ. In some embodiments, a voltage measured at positive and negative input/output terminals 117 and 119 at both ends of the battery module 110 may be about 1,209 V (e.g., 1,209 V = 0.0001 x 300 Point x 300 A + 1,200 V).

Assuming that the contact resistance 115 of a normal contact portion without an assembly defect is about 0.1 mΩ, in a normal battery pack, a voltage difference of about 9 V may occur in a battery module if about 300 A flows, but if an assembly defect occurs in the contact portion, a voltage difference of about 9 V or more may occur. There is a possibility of fire occurring in a contact portion with an assembly defect, and thus, it may be suitable to detect assembly defects in advance.

If charging/discharging a battery, there may be a difference between a voltage value calculated by adding up all cell voltages and a voltage value measured for a battery module due to an internal resistance value. For example, by using measurement points (e.g., preset measurement points) for components of a battery module and a BCU provided in a battery pack, an internal resistance value of each component may be measured. In one or more embodiments, internal resistance values for the components of the battery module and the BCU provided in the battery pack may be stored (e.g., pre-stored) in a memory.

For example, as shown in FIG. 2, the measurement points (e.g., preset measurement points) according to embodiments of the present disclosure may include the positive and negative input/output terminals 117 and 119 at respective ends of the battery module 110, positive and negative input/output terminals 101 and 102 of the battery pack, a measurement point Rack V+ between the positive input/output terminal 117 of the battery module 110 and the contactor, a measurement point Rack P+ between the fuse and the positive input/output terminal 101 of the battery pack, a measurement point Rack V- between the shunt resistor and the negative input/output terminal 102 of the battery pack, and the like.

In one or more embodiments, in the method of diagnosing an assembly defect of a battery pack, according to embodiments of the present disclosure, an internal resistance value of each component may be measured by using measurement points (e.g., preset measurement points). In one or more embodiments, an assembly defect of each component may be detected by using a voltage value measured between measurement points (e.g., preset measurement points). For example, an assembly defect of the contactor may be detected by using internal resistance and voltage values measured between the measurement point Rack V- and the measurement point Rack P+.

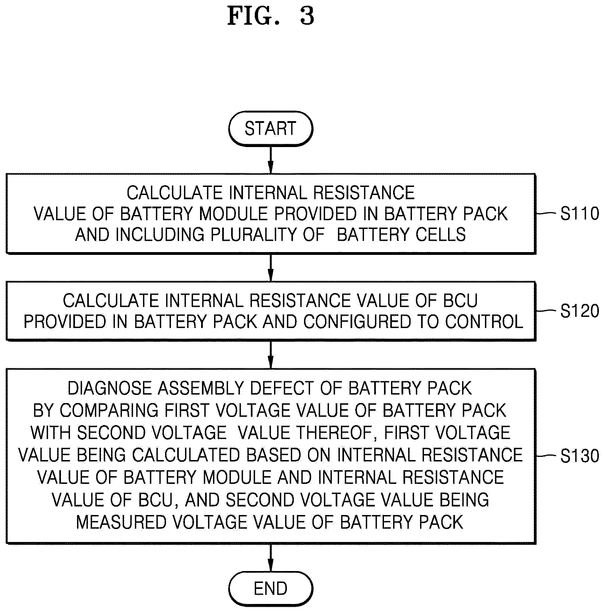

FIG. 3 is a flowchart for explaining a method of diagnosing an assembly defect of a battery pack, according to embodiments of the present disclosure. The method of diagnosing an assembly defect of a battery pack, according to embodiments of the present disclosure, may be performed by the processor 150 shown in FIG. 1.

First, referring to FIG. 3, in operation S110, the processor 150 may calculate an internal resistance value of the battery module 110 that is provided in the battery pack and that includes a plurality of battery cells 111.

In one or more embodiments, the processor 150 according to embodiments of the present disclosure may obtain an internal resistance value measured (e.g., pre-measured) by using both ends of the battery module 110 as measurement points.

In one or more embodiments, the processor 150 according to embodiments of the present disclosure may calculate the internal resistance value of the battery module 110 based on an amount of change of an internal resistance value according to a battery deterioration state stored (e.g., pre-stored) according to a model of the battery cell 111.

In operation S120, the processor 150 may calculate an internal resistance value of the BCU 100 that is provided in the battery pack and that is configured to control charging/discharging of the battery module 110.

The processor 150 according to embodiments of the present disclosure may calculate the internal resistance value of the BCU 100 based on an internal resistance value measured (e.g., pre-measured) by using measurement points (e.g., preset measurement points) for one or more components (e.g., for each component) assembled and provided in the BCU 100.

In operation S130, the processor 150 may diagnose an assembly defect of the battery pack by comparing a first voltage value of the battery pack with a second voltage value of the battery pack, the first voltage value being calculated based on the internal resistance value of the battery module 110 and the internal resistance value of the BCU 100, and the second voltage value being a measured voltage value of the battery pack.

The processor 150 according to embodiments of the present disclosure may calculate, based on a current deterioration state, an internal resistance value of the battery pack by adding the internal resistance value of the battery module 110 and the internal resistance value of the BCU 100, the internal resistance value of the battery module 110 reflecting the amount of change of the internal resistance value according to the battery deterioration state.

In one or more embodiments, the processor 150 may calculate the first voltage value by multiplying the internal resistance value of the battery pack by a value of a current flowing through both ends of the battery pack. In one or more embodiments, the processor 150 may compare a magnitude of the first voltage value with a magnitude of the second voltage value obtained by measuring a voltage at both ends of the battery pack.

In one or more embodiments, if the magnitude of the second voltage value is greater than the magnitude of the first voltage value, the processor 150 according to embodiments of the present disclosure may diagnose that there is an assembly defect in the battery pack.

An apparatus for diagnosing an assembly defect of a battery pack, according to embodiments of the present disclosure, may diagnose an assembly defect of the battery pack by comparing a first voltage value of the battery pack with a second voltage value of the battery pack, the first voltage value being calculated based on the internal resistance value of the battery module 110 and the internal resistance value of the BCU 100, and the second voltage value being a measured voltage value of the battery pack.

For example, the first voltage value may be calculated as V₁ = |(Q1*(1+E)+Q2) x (A-B)I. In one or more embodiments, the second voltage value may be calculated as V₂ = ΔV(D-C). Here, Q1 may represent the internal resistance value of the battery module 110, Q2 may represent the internal resistance value of the BCU 100, A may represent a current applied to the battery pack, B may represent an initial current of the battery pack, V(C) may represent a voltage of the battery pack before current application, V(D) may represent a voltage of the battery pack 2 seconds after current application, and E may represent a rate of change of an internal resistance value according to a battery deterioration state. Here, E is described in detail below.

In one or more embodiments, if the magnitude of the second voltage value is greater than the magnitude of the first voltage value, the apparatus for diagnosing an assembly defect of a battery pack, according to embodiments of the present disclosure, may diagnose that there is an assembly defect in the battery pack. For example, if V₂ > V₁, it may be diagnosed that there is an assembly defect in the battery pack, and if V₂ ≤ V₁, it may be diagnosed that the battery pack is normal with no detected assembly defects.

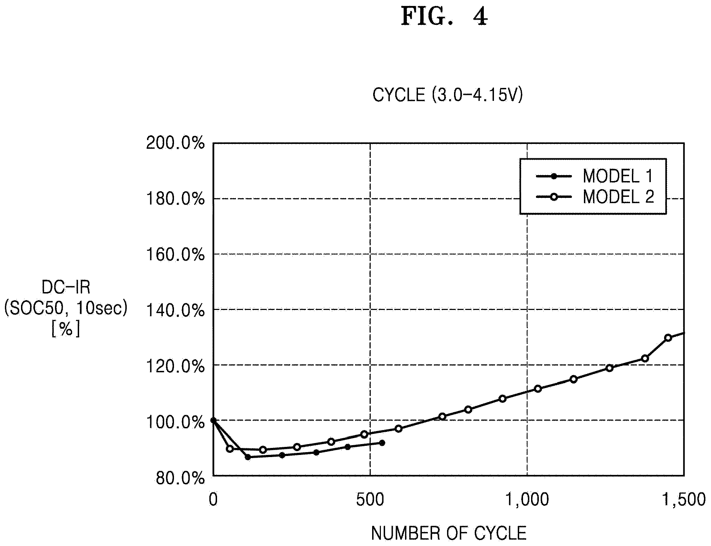

The apparatus for diagnosing an assembly defect of a battery pack, according to embodiments of the present disclosure, may calculate the internal resistance value of the battery module 110 based on an amount of change of an internal resistance value according to a battery deterioration state stored (e.g., pre-stored) according to a model of the battery cell 111. For example, referring to FIG. 4, a diagram for explaining an amount of change of an internal resistance value according to a battery deterioration state, according to embodiments of the present disclosure, is shown.

To accurately diagnose an assembly defect in the battery module 110, it may be suitable to reflect an increase in an internal resistance value according to a deterioration state of the battery cell 111. A rate of change of an internal resistance value according to a battery deterioration state may vary for each model of the battery cell 111. In one or more embodiments, data on the rate of change of the internal resistance value according to the battery deterioration state for each model of the battery cell 111 may be stored (e.g., pre-stored) in a memory.

For example, referring to FIG. 4, a rate of change of an internal resistance value according to a battery charging/discharging cycle is shown for battery cell model 1 (MODEL 1) and battery cell model 2 (MODEL 2). For example, one battery cycle may represent a cycle in which an SOC is discharged from about 100% to about 0%. In one or more embodiments, a battery may deteriorate as a battery cycle increases, and thus, a deterioration state of the battery may be estimated based on the battery cycle.

For example, referring to FIG. 4, it is shown that, for battery cell model 2, an internal resistance value of a battery has increased by about 130% after about 1,500 cycles. A rate of increase in an internal resistance value according to a battery cycle increases approximately linearly, and thus may be predicted with a trend line.

In the present disclosure, a first voltage value may be calculated as V₁ = |(Q1*(1+E)+Q2) x (A-B)|, and E may represent a rate of change of an internal resistance value according to a battery deterioration state. In some embodiments, if an internal resistance value of a battery increases to about 130% after about 1,500 cycles for battery cell model 2, a value of E may be about 0.3.

According to the present disclosure, by more accurately estimating an internal resistance value of a battery by applying a rate of increase in the internal resistance value according to a deterioration state of the battery, an assembly defect of a battery pack may be diagnosed more accurately.

The various embodiments described above are merely examples, and are not necessarily distinguished and implemented independently of each other. The embodiments described in the present specification may be implemented in combination with each other.

The various embodiments described above may be implemented in the form of a computer program executable by various components on a computer, and such a computer program may be recorded on a computer-readable medium. At this time, the medium may continuously store computer-executable programs, or may temporarily store the computer-executable programs for execution or downloading. In one or more embodiments, the medium may be any one of various recording media or storage media in which a single piece or plurality of pieces of hardware are combined, and the medium is not limited to a medium directly connected to a computer system, but may be distributed on a network. Examples of the medium may include a magnetic medium, such as a hard disk, a floppy disk, and a magnetic tape, an optical recording medium, such as a CD-ROM and a DVD, a magneto-optical medium, such as a floptical disk, and ROM, RAM, a flash memory, and the like, which are configured to store program instructions. Other examples of the medium may include a recording medium and a storage medium managed by application stores distributing applications or by websites, servers, and the like supplying or distributing other various types of software.

In the present specification, the term "unit" or "module" may be a hardware component, such as a processor or a circuit, and/or a software component that is executed by a hardware component, such as a processor. For example, the "unit" or "module" may be implemented by components, such as software components, object-oriented software components, class components, and task components, processes, functions, attributes, procedures, subroutines, segments of program code, drivers, firmware, micro code, circuits, data, a database, data structures, tables, arrays, and variables.

According to the present disclosure, a method, computer program, and apparatus for diagnosing an assembly defect of a battery, which may effectively diagnose an assembly defect in a process of diagnosing an assembly defect of a battery pack, may be provided. However, the scope of the present disclosure is not limited by this effect.

It should be understood that embodiments described herein should be considered in a descriptive sense only and not for purposes of limitation. Descriptions of aspects within the embodiments should typically be considered as available for other similar aspects in other embodiments. While one or more embodiments have been described with reference to the figures, it will be understood by those of ordinary skill in the art that various changes in form and details may be made therein without departing from the scope of the present disclosure as defined by the appended claims, with functional equivalents thereof to be included therein.

## Claims

1. A method of diagnosing an assembly defect of a battery pack, the method comprising:
calculating an internal resistance value of a battery module (110) comprising battery cells (111) in the battery pack;
calculating an internal resistance value of a battery control unit, BCU, (100) in the battery pack and configured to control charging/discharging of the battery module (110); and
comparing a first voltage value of the battery pack with a second voltage value of the battery pack, the first voltage value being calculated based on the internal resistance value of the battery module (110) and the internal resistance value of the BCU (100), and the second voltage value being a measured voltage value of the battery pack.

2. The method as claimed in claim 1, wherein the calculating of the internal resistance value of the battery module (110) comprises using both ends of the battery module (110) as measurement points.

3. The method as claimed in claim 1 or 2, wherein the calculating of the internal resistance value of the battery module (110) is based on an amount of change of the internal resistance value of the battery module (110) corresponding to a battery deterioration state corresponding to a battery cell model.

4. The method as claimed in claim 3, further comprising:
calculating, based on a current deterioration state, an internal resistance value of the battery pack by adding the internal resistance value of the battery module (110) and the internal resistance value of the BCU (100), the internal resistance value of the battery module (110) reflecting the amount of the change of the internal resistance value according to the battery deterioration state;
calculating the first voltage value by multiplying the internal resistance value of the battery pack by a value of a current flowing through both of the ends of the battery pack; and
comparing a magnitude of the first voltage value with a magnitude of the second voltage value obtained by measuring a voltage at both of the ends of the battery pack.

5. The method as claimed in claim 4, further comprising determining that the magnitude of the second voltage value is greater than the magnitude of the first voltage value.

6. The method as claimed in any one of the preceding claims, wherein the calculating of the internal resistance value of the BCU (100) is based on using measurement points for components in the BCU (100).

7. A computer program stored on a recording medium to execute the method as claimed in any one of the preceding claims by using a computing device.

8. An apparatus for diagnosing an assembly defect of a battery pack, the apparatus comprising:
a battery module (110) in the battery pack and comprising battery cells (111);
a battery control unit, BCU, (100) in the battery pack and configured to control charging/discharging of the battery module (110); and
a processor (150) configured to calculate an internal resistance value of the battery module (110), to calculate an internal resistance value of the BCU (100), and to diagnose the assembly defect of the battery pack by comparing a first voltage value of the battery pack with a second voltage value of the battery pack, the first voltage value being calculated based on the internal resistance value of the battery module (110) and the internal resistance value of the BCU (100), and the second voltage value being a measured voltage value of the battery pack.

9. The apparatus as claimed in claim 8, wherein the processor (150) is further configured to use both ends of the battery module (110) as measurement points.

10. The apparatus as claimed in claim 8 or 9, wherein the processor (150) is further configured to calculate the internal resistance value of the battery module (110) based on an amount of change of the internal resistance value of the battery module (110) corresponding to a battery deterioration state corresponding to a battery cell model.

11. The apparatus as claimed in claim 10, wherein the processor (150) is further configured to:
calculate, based on a current deterioration state, an internal resistance value of the battery pack by adding the internal resistance value of the battery module (110) and the internal resistance value of the BCU (100), the internal resistance value of the battery module (110) reflecting the amount of the change of the internal resistance value according to the battery deterioration state;
calculate the first voltage value by multiplying the internal resistance value of the battery pack by a value of a current flowing through both ends of the battery pack; and
compare a magnitude of the first voltage value with a magnitude of the second voltage value obtained by measuring a voltage at both of the ends of the battery pack.

12. The apparatus as claimed in claim 11, wherein the processor (150) is further configured to, when the magnitude of the second voltage value is greater than the magnitude of the first voltage value, diagnose that there is the assembly defect in the battery pack.

13. The apparatus as claimed in any one of claims 8 to 12, wherein the processor (150) is further configured to calculate the internal resistance value of the BCU (100) based on using measurement points for components assembled and provided in the BCU (100).

14. The apparatus as claimed in any one of claims 8 to 13, wherein the BCU (100) includes the processor (150), a contactor, a fuse, and a shunt resistor.

15. The apparatus as claimed in any one of claims 8 to 14, wherein the battery cells (111) are rechargeable secondary batteries selected from at least one among a nickel-cadmium battery, a lead acid battery, a nickel metal hydride battery, a lithium ion battery, a lithium polymer battery.
